# EUROPÄISCHE PATENTSCHRIFT

(11) **EP 0 878 827 B1**
(45) Veröffentlichungstag und Bekanntmachung des Hinweises auf die Patenterteilung: **27.02.2002**
(21) Anmeldenummer: 98108907.1
(22) Anmeldetag: 15.05.1998
(51) Int. Cl.: H01J 49/14, G01N 23/225, H01J 37/256, H01J 37/252

(54) **Verfahren zur Analyse einer Probe**
Sample analysis method
Méthode d'analyse d'un échantillon

(30) Priorität: 15.05.1997 DE 19720458
(43) Veröffentlichungstag der Anmeldung: 18.11.1998
(73) Patentinhaber: Atomika Instruments GmbH, 85764 Oberschleissheim (DE)
(72) Erfinder: Maul, Johann L. Dr., 85229 Markt Indersdorf (DE); Dowsett, Mark G., Balsall Common, West Midlands CV77Ps (GB)
(74) Vertreter: Graf Lambsdorff, Matthias, Dr.

(56) Entgegenhaltungen:
- DE-A- 4 205 752
- JP-A- 3 129 656
- US-A- 5 350 919

## Beschreibung

Die Erfindung betrifft ein Verfahren zur Analyse einer Probe nach dem Oberbegriff des Patentanspruchs 1 und eine Vorrichtung zur Durchführung des Verfahrens.

Bei der Analyse von Proben durch Sekundärionen-Massenspektroskopie (SIMS) ist man bestrebt, gleichzeitig eine gute Tiefenauflösung, niedrige Nachweisgrenzen und die Korrektur der durch den sogenannten "Anlaufeffekt" verursachten Verfälschungen zu erreichen. Der "Anlaufeffekt" kommt dadurch zustande, daß mit beginnendem Abtrag der Probe durch die Primärionen, letztere zu einem Teil in die Probe eingebaut werden und somit die weitere Bildung von Sekundärionen begünstigen. Es ist ein Verfahren bekannt, bei dem der die Probe abtragende Primärionenstrahl unter einem Einfallswinkel von 45° Grad oder mehr bezüglich der Normalen zur Probenoberfläche auf die zu untersuchende Probe gerichtet wird. Ein solches Verfahren hat den Vorteil, daß beispielsweise die Konzentration eines Dotierstoffes in einer Festkörperprobe mit verbesserter Tiefenauflösung gemessen werden kann. Der Nachteil dieses Verfahrens liegt jedoch darin, daß im allgemeinen die Ausbeute an Sekundärionen, die durch die Probe emittiert werden, und damit die Nachweisempfindlichkeit vermindert ist, da der Einbau von Primärionen in die Probe bei den erwähnten hohen Beschußwinkeln reduziert ist. Bekanntermaßen begünstigt dieser bei senkrechtem Beschuß relativ starke Einbau von Primärionen in die Probe die Bildung von Sekundärionen, insbesondere bei der Auswahl einer elektropositiven bzw elektronegativen Primärionenart (vorzugsweise Cäsium bzw. Sauerstoff) die Bildung von negativen bzw. positiven Sekundärionen.

In der deutschen Patentschrift DE-PS 42 05 752 ist eine Anordnung beschrieben, mit der dieser Rückgang in der Sekundärionenausbeute weitgehend kompensiert werden kann. Die Anordnung sieht vor, daß ein zweiter Teilchenstrahl relativ niedriger kinetischer Energie unter senkrechtem Einfall auf die Probe gerichtet wird und einen oberflächennahen Bereich der Probe somit mit Teilchen dieser Art, vorzugsweise Sauerstoff oder Cäsium anreichert. Die zweite Teilchenstrahl quelle kann entweder gleichzeitig mit der ersten Teilchenstrahlquelle betrieben werden und somit die Probe während dem Abtrag durch die Primärionen simultan anreichern oder im Intervallbetrieb mit der ersten Teilchenstrahlquelle betrieben werden. Die beschriebene Anordnung optimiert zwar weitgehend die eingangs genannten drei Anforderungen, hat jedoch den Nachteil, daß sie durch den Aufbau von zwei Teilchenstrahlquellen relativ voluminös und unhandlich wird.

Die US-A-5 350 919 beschreibt ein Sekundärionen-Massenspektroskopieverfahren, durch welches eine quantitative Analyse von Proben auf das Vorhandensein von Targetelementen möglich ist.

Die JP 03129656 beschreibt ein Sekundärionen-Massenspektrometer mit stabilisierten, positiven und negativen Hochspannungs-Leistungsversorgungen, aus denen durch Spannungsteilung mittels Potentiometerschaltungen die Elektroden der Primärionenquelle und die zu untersuchende Probe mit Spannungen versorgt werden können, die jeweils in engen Grenzen regelbar sind.

Der vorliegenden Erfindung liegt somit die Aufgabe zugrunde, ein verbessertes Verfahren zur Sekundärionen-Massenspektroskopie und eine Vorrichtung zur Durchführung des Verfahrens anzugeben, durch die sowohl die eingangs genannten Anforderungen gleichzeitig optimiert werden können als auch ein verhältnismäßig einfacher Aufbau ermöglicht wird.
Diese Aufgabe wird durch die kennzeichnenden Merkmale des Patentanspruchs 1 gelöst.

Demgemäß sieht das erfindungsgemäße Verfahren vor, daß in einem ersten Verfahrensschritt die kinetische Energie der von einer Primärionenquelle ausgesandten oder auf eine Probenoberfläche auftreffenden Primärionen auf einen relativ niedrigen Wert eingestellt wird, so daß die Oberfläche der Probe mit Primärionen angereichert wird und eine Abtragung der Oberfläche der Probe durch Sputtern im wesentlichen nicht stattfindet, und daß in einem zweiten Verfahrensschritt die kinetische Energie der von der Primärionenquelle ausgesandten Primärionen auf einen relativ hohen Wert eingestellt wird, so daß die Oberfläche durch den Primärionenstrahl abgetragen wird.

Somit wird für die Anreicherung der Probe wie für deren Abtragung ein und dieselbe Teilchenstrahlquelle verwendet, wodurch eine Vorrichtung zur Durchführung des Verfahrens relativ kompakt ist.

Vorteilhafte Ausgestaltungen sind in den Unteransprüchen angegeben. Insbesondere kann demgemäß kann die Einstellung der kinetischen Energie der Primärionen entweder durch Einstellung der Emissionsparameter der Primärionenquelle oder durch Variation eines an der Probe anliegenden Potentials erfolgen. Die unabhängigen Ansprüche 8 und 9 betreffen Vorrichtungen zur Durchführung des Verfahrens.

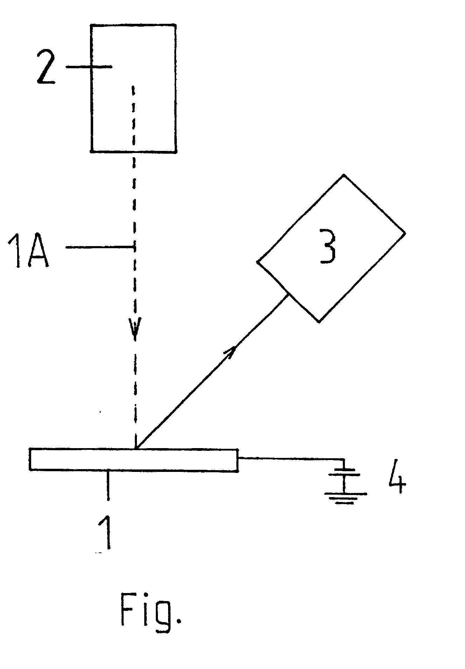

In der Figur ist eine Vorrichtung zur Durchführung des Verfahrens schematisch dargestellt.

Für die Analyse einer Probe 1 wird ein Primärionenstrahl einer Primärionenquelle 2 unter einem beliebigen Beschußwinkel bezüglich der Normalen zur Probenoberfläche auf diese gerichtet und die von der Probe ausgelösten Sekundärionen in einem Massenspektrometer 3 analysiert. In der Prinzipskizze der Figur ist der Beschußwinkel 0° Grad. Der Beschußwinkel kann aber beispielsweise auch größer sein, insbesondere wenn damit eine Verbesserung der Tiefenauflösung erwartet werden kann. Dies ist beispielsweise bei Verwendung von Cäsium als Primärionenart der Fall. Das Massenspektrometer 3 ist vorzugsweise mit seiner ionenoptischen Achse in einem Winkel von annähernd 90° Grad in Bezug auf den Primärionenstrahl ausgerichtet.

Im ersten Verfahrensschritt ist die Energie des Teilchenstrahls 1A vorzugsweise kleiner als die Schwellenenergie für das Sputtern der Probe 1, also typischerweise kleiner als 50 eV. Somit wird ein oberflächennaher Bereich der Probe 1 mit Primärionen, vorzugsweise Sauerstoff- oder Cäsiumionen angereichert. Im zweiten Verfahrensschritt wird die Energie der Primärionen beträchtlich erhöht, beispielsweise auf einen Wert von 150 eV bis 10 keV, vorzugsweise jedoch auf einen Wert oberhalb von 1 keV, so daß die Probe 1 durch den Ionenbeschuß abgetragen werden kann. Wie bereits erläutert, begünstigen die im ersten Verfahrensschritt implantierten Primärionen die Bildung der Sekundärionen im zweiten Verfahrensschritt.

Ein wesentlicher Vorteil des Verfahrens liegt darin, daß der eingangs beschriebene "Anlaufeffekt" vermieden werden kann, da gleich zu Beginn - im ersten Verfahrensschritt - ein ober flächennaher Bereich angereichert wird. Somit wird beim Sputtern im zweiten Verfahrensschritt von Anfang an eine hohe Ausbeute an Sekundärionen erzielt, so daß über den gesamten Tiefenbereich einschließlich der Oberfläche gleiche Voraussetzungen für die Analyse vorliegen.

Gemäß einer ersten Ausführungsform der Erfindung wird die kinetische Energie der Primärionen durch geeignete Wahl der Emissionsparameter der Primärionenquelle 2 eingestellt. Die kinetische Energie der Primärionen am Ausgang der Primärionenquelle 2 sollte über einen möglichst großen Bereich, von <50 eV bis >5000 eV einstellbar sein. Die Änderung der Energie sollte dabei möglichst ohne Vornahme mechanischer Eingriffe, d.h. lediglich durch Änderung elektrischer Potentiale an Elektroden o.dgl. - vorzugsweise computergesteuert - erfolgen können. Vorzugsweise sollte der Fokusdurchmesser des Primärionenstrahls im zweiten Verfahrensschritt kleiner sein als im ersten Verfahrensschritt, damit gewährleistet ist, daß bei der Analyse nur Probenbereiche abgetragen werden, die im ersten Verfahrensschritt implantiert wurden. Die Erzeugung eines kleineren Fokus ergibt sich im zweiten Verfahrensschritt im allgemeinen schon in vorteilhafter Weise durch die höhere Ionenenergie oder wird durch diese zumindest ionenoptisch erleichtert. Im übrigen hängt die genaue Wahl der Energie der Primärionen im zweiten Verfahrensschritt auch von den Erfordernissen hinsichtlich lateraler Auflösung und Tiefenauflösung bei der Analyse ab. Wenn eine gute Tiefenauflösung auf Kosten der lateralen Auflösung angestrebt wird, so wird die Ionenenergie auf einen relativ niedrigen Wert eingestellt. Umgekehrt gilt, daß für eine gute laterale Auflösung auf Kosten der Tiefenauflösung ein relativ hoher Wert für die Ionenenergie gewählt wird. Der Wert für die Ionenenergie kann auch ortsselektiv variiert werden, wenn z.B. für bestimmte Probenbereiche eine hohe Tiefenauflösung gewünscht wird und für andere Probenbereiche eine geringere Tiefenauflösung als ausreichend erscheint. Weiterhin können auch zeitlich aufeinanderfolgend bei der Analyse verschiedene lonenenergien gewählt werden, wenn z.B. in unterschiedlichen Tiefenbereichen unterschiedliche Tiefenauflösungen gewünscht werden.

Gemäß einer zweiten Ausführungsform der Erfindung wird die kinetische Energie der Primärionen dadurch eingestellt, daß die Probe 1 mit einer Gleichspannungsquelle 4 verbunden und somit mit einem Potential beaufschlagt wird, durch das die Primärionen beeinflußt werden. Das hat den Vorteil, daß die Ionenquelle nicht verändert werden muß und somit verhältnismäßig einfach aufgebaut sein kann. Beispielsweise kann die Primärionenenergie in beiden Verfahrensschritten auf konstant 250 eV eingestellt sein, während die Probe im ersten Verfahrensschritt auf einem positiven Potential von 200 V liegt, so daß die Primärionen auf eine Energie von 50 eV abgebremst werden. Im zweiten Verfahrensschritt des Sputterns wird das Probenpotential dann auf beispielsweise 0 V reduziert, so daß die Primärionen mit ihrer Ausgangsenergie von 250 eV die Probe erreichen.

Die beiden Verfahrensschritte des Implantierens und Abtragens können auch mehrmals alternierend durchgeführt werden, wobei stets nach Abtragen einer bestimmten Schichtdicke ein Implantierungsschritt eingeschoben. Insbesondere bei Analyse von Tiefenprofilen größerer Tiefe kann sich dies als vorteilhaft erweisen.

Die Anreicherung von Sauerstoff bzw. Cäsium kann auch derart durchgeführt werden, daß nur ausgewählte Stellen auf der Probe mit Sauerstoff bzw. Cäsium angereichert werden und somit nur an diesen Stellen der Ionisierungsgrad erhöht wird. Damit kann erreicht werden, daß Probenbereiche, die die Messung stören, weniger stark in Erscheinung treten, da diese nicht mit Sauerstoff bzw. Cäsium angereichert worden sind. Bei Tiefenprofilmessungen kann dieses "chemical gating" durch Alternieren zwischen hohen (>200eV) und niedrigen Primärionenenergien (<100eV) während der gesamten Tiefenprofilmessung durchgeführt werden.

## Patentansprüche

1. Verfahren zur Analyse einer Probe (1) mit einer Primärionenquelle (2) und einem Massenspektrometer (3), wobei
- bei der Analyse ein von der Primärionenquelle (2) emittierter Primärionenstrahl (1A) auf die Oberfläche der Probe (1) gerichtet wird und
- das Massenspektrometer (3) die von der Probe (1) ausgesandten Sekundärionen detektiert,
**dadurch gekennzeichnet, daß**
- in einem ersten Verfahrensschritt die kinetische Energie der ausgesandten oder auftreffenden Primärionen auf einen relativ niedrigen Wert eingestellt wird, so daß die Oberfläche der Probe (1) mit Primärionen angereichert wird und eine Abtragung der Oberfläche der Probe (1) im wesentlichen nicht stattfindet, und
- in einem zweiten Verfahrensschritt die kinetische Energie der Primärionen auf einen relativ hohen Wert eingestellt wird, so daß die Oberfläche der Probe (1) durch den Primärionenstrahl abgetragen wird.

2. Verfahren nach Anspruch 1,
**dadurch gekennzeichnet, daß**
- die kinetische Energie der Primärionen durch Änderung der Parameter der Primärionenquelle (2) eingestellt wird.

3. Verfahren nach Anspruch 1,
**dadurch gekennzeichnet, daß**
- die Probe (1) mit einem elektrischen Potential beaufschlagt wird und die kinetische Energie der auftreffenden Primärionen durch Veränderung des Potentials eingestellt wird.

4. Verfahren nach Anspruch 2 oder 3,
**dadurch gekennzeichnet, daß**
- die kinetische Energie der Primärionen im ersten Verfahrensschritt kleiner als 50 eV ist.

5. Verfahren nach einem der Ansprüche 2 bis 4,
**dadurch gekennzeichnet, daß**
- die kinetische Energie der Primärionen im zweiten Verfahrensschritt größer als 150 eV ist.

6. Verfahren nach einem oder mehreren der vorhergehenden Ansprüche,
**dadurch gekennzeichnet, daß**
- der erste und der zweite Verfahrensschritt mehrmals alternierend durchgeführt werden.

7. Verfahren nach einem oder mehreren der vorhergehenden Ansprüche,
**dadurch gekennzeichnet, daß**
- im ersten Verfahrensschritt ausgewählte Stellen auf der Probe mit Primärionen angereichert werden, so daß nichtausgewählte Probenbereiche bei der Messung im zweiten Verfahrensschritt weniger stark in Erscheinung treten.

8. Computergesteuerte Vorrichtung zur Durchführung des Verfahrens nach Anspruch 2, mit
- genau einer Primärionenquelle (2), welche in Bezug auf die zu untersuchende Probe (1) derart ausrichtbar ist, daß ein von der Primärionenquelle (2) emittierter Primärionenstrahl (1A) auf die Probe (1) auftrifft, und
- einem Massenspektrometer (3) zur Detektion der von der Probe (1) emittierten Sekundärionen, wobei
- eine Computersteuerung die Einstellung der elektrischen Potentiale an den Elektroden der Primärionenquelle (2) und die Änderung der elektrischen Potentiale zwischen den beiden Verfahrensschritten bewirkt.

9. Vorrichtung zur Durchführung des Verfahrens nach Anspruch 3, mit
- genau einer Primärionenquelle (2), welche in Bezug auf die zu untersuchende Probe (1) derart ausrichtbar ist, daß ein von der Primärionenquelle (2) emittierter Primärionenstrahl (1A) auf die Probe (1) auftrifft, und
- einem Massenspektrometer (3) zur Detektion der von der Probe (1) emittierten Sekundärionen, wobei
- die Vorrichtung eine einstellbare Gleichspannungsquelle (4) aufweist und ein Pol der Gleichspannungsquelle (4) direkt mit der Probe (1) verbindbar ist und somit die kinetische Energie der auftreffenden Primärionen durch Einstellung des elektrischen Potentials der Probe (1) einstellbar ist.

## Claims

1. A sample (1) analysis method, comprising a primary ion source (2) and a mass spectrometer (3), wherein
- a primary ion beam (1A) emitted from said primary ion source (2) is directed to the surface of sample (1) while the analysis is being performed, and wherein
- the mass spectrometer (3) detects the secondary ions emitted from said sample (1),
**characterized in that**
- in a first method step, the kinetic energy of the emitted or impinging primary ions is set to a relatively low value to enrich the surface of sample (1) with primary ions and to substantially avoid clearing of the surface of sample (1), and
- **in that**, in another method step, the kinetic energy of the primary ions is set to a relatively high value to enable clearing of the surface of the sample (1) by means of said primary ion beam.

2. The method as set forth in claim 1,
**characterized in that**
- the kinetic energy of the primary ions is set by changing the parameters of said primary ion source (2).

3. The method as set forth in claim 1,
**characterized in that**
- the sample (1) is supplied with an electric potential and the kinetic energy of the impinging primary ions is set by changing said potential.

4. The method as set forth in claim 2 or 3,
**characterized in that**
- the kinetic energy of the primary ions is smaller than 50 eV in said first method step.

5. The method as set forth in any of claims 2 to 4,
**characterized in that**
- the kinetic energy of the primary ions is greater than 150 eV in said second method step.

6. The method as set forth in one or several of the preceding claims,
**characterized in that**
- said first and said second method step are performed for several times in alternating manner.

7. The method as set forth in one or several of the preceding claims,
**characterized in that**
- in said first method step, selected areas on said sample are enriched with primary ions so that non-selected sample areas remain in the background during the measurement taking place in said second method step.

8. A computer-controlled device used to perform the method as set forth in claim 2, comprising
- exactly one primary ion source (2) which can be directed with regard to sample (1) to be examined in such a manner that a primary ion beam (1A) emitted from said primary ion source (2) impinges said sample (1), and
- a mass spectrometer (3) to detect the secondary ions emitted from said sample (1), wherein
- the setting of the electric potentials at the electrodes of said primary ion source (2) and the change of the electric potentials between the two method steps is performed by means of a computer control.

9. The device used to perform the method as set forth in claim 3, comprising
- exactly one primary ion source (2) which can be directed with regard to sample (1) to be examined in such a manner that a primary ion beam (1A) emitted from said primary ion source (2) impinges said sample (1), and
- a mass spectrometer (3) to detect the secondary ions emitted from said sample (1), wherein
- said device includes an adjustable constant voltage source (4), and wherein a pole of said constant voltage source (4) is directly connectable to said sample (1) so that the kinetic energy of the impinging primary ions can be set by adjusting the electric potential of sample (1).

## Revendications

1. Procédé d'analyse d'un échantillon (1) au moyen d'une source d'ions primaires (2) et d'un spectromètre de masse (3), lors de l'analyse, un faisceau (lA) d'ions primaires émis par la source d'ions primaires (2) étant dirigé sur la surface de l'échantillon (1) et le spectromètre de masse (3) détectant les ions secondaires émis par l'échantillon (1), **caractérisé en ce que**, dans une première opération du procédé, on règle l'énergie cinétique des ions primaires émis ou frappant la surface sur une valeur relativement faible, de telle sorte que la surface de l'échantillon (1) est enrichie en ions primaires et qu'il n'y a sensiblement aucune érosion de la surface de l'échantillon (1), et, dans une deuxième opération du procédé, on règle l'énergie cinétique des ions primaires sur une valeur relativement élevée, de telle sorte que la surface de l'échantillon (1) est érodée par le faisceau d'ions primaires.

2. Procédé selon la première revendication, **caractérisé en ce que** l'énergie cinétique des ions primaires se règle par modification des paramètres de la source d'ions primaires (2).

3. Procédé selon la première revendication, **caractérisé en ce qu'**on applique à l'échantillon (1) un potentiel électrique et que l'énergie cinétique des ions primaires qui frappent l'échantillon se règle par modification du potentiel.

4. Procédé selon la revendication 2 ou 3, **caractérisé en ce que** l'énergie cinétique des ions primaires, dans la première opération du procédé, est inférieure à 50 eV.

5. Procédé selon l'une des revendications 2 à 4, **caractérisé en ce que** l'énergie cinétique des ions primaires, dans la deuxième opération du procédé, est supérieure à 150 eV.

6. Procédé selon une ou plusieurs des revendications précédentes, **caractérisé en ce que** la première et la deuxième opérations du procédé sont exécutées plusieurs fois en alternance.

7. Procédé selon une ou plusieurs des revendications précédentes, **caractérisé en ce que**, dans la première opération du procédé, des endroits sélectionnés de l'échantillon sont enrichis en ions primaires, de telle sorte que, lors de la mesure effectuée dans la deuxième opération du procédé, les parties non sélectionnées de l'échantillon se manifestent moins fortement.

8. Dispositif piloté par ordinateur, destiné à appliquer le procédé de la revendication 2, comportant une seule source d'ions primaires (2) pouvant être orientée, par rapport à l'échantillon (1) à étudier, de telle manière qu'un faisceau d'ions primaires (lA) émis par la source d'ions primaires (2) frappe l'échantillon (1), et un spectromètre de masse (3) servant à détecter les ions secondaires émis par l'échantillon (1), un système de commande par ordinateur effectuant le réglage des potentiels électriques appliqués aux électrodes de la source d'ions primaires (2) et la modification des potentiels électriques entre les deux opérations du procédé.

9. Dispositif destiné à appliquer le procédé de la revendication 3, comportant une seule source d'ions primaires (2) pouvant être orientée, par rapport à l'échantillon (1) à étudier, de telle manière qu'un faisceau d'ions primaires (lA) émis par la source d'ions primaires (2) frappe l'échantillon (1), et un spectromètre de masse (3) servant à détecter les ions secondaires émis par l'échantillon (1), ce dispositif présentant une source réglable de tension continue (4) et un pôle de cette source de tension continue (4) pouvant être relié directement à l'échantillon (1), ce dont il résulte que l'énergie cinétique des ions primaires qui frappent l'échantillon est réglable par réglage du potentiel électrique de l'échantillon (1).
